# EUROPÄISCHE PATENTSCHRIFT

(11) **EP 0 280 913 B1**
(45) Veröffentlichungstag und Bekanntmachung des Hinweises auf die Patenterteilung: **08.05.1996**
(21) Anmeldenummer: 88101664.6
(22) Anmeldetag: 05.02.1988
(51) Int. Cl.: H03M 13/00

(54) **Gerät zum Empfang von Daten**
Apparatus for data reception
Appareil pour la réception de données

(30) Priorität: 06.03.1987 DE 3707152
(43) Veröffentlichungstag der Anmeldung: 07.09.1988
(73) Patentinhaber: Blaupunkt-Werke GmbH, D-31132 Hildesheim (DE)
(72) Erfinder: Hegeler, Wilhelm, D-3200 Hildesheim (DE)

(56) Entgegenhaltungen:
- JP-A-62 258 530
- US-A- 4 167 701
- PATENT ABSTRACTS OF JAPAN vol. 7, no. 186 (E-193)(1331) 16. August 1983 & JP-A-58 090 853
- ABSTRACTS OF THE TRANSACTIONS OF THE INSTITUTE OF ELECTRONICS AND COMMUNICATION Bd. 58, Nr. 1, Janaur 1975, Tokyo, JP, SS. 7-8; H. MIYAKAWA, T. KANEKO: 'Decoding algorithm of error correcting codes by use of analog weights'
- IEEE TRANSACTIONS ON COMMUNICATION TECHNOLOGY, Bd. 15, Nr. 3, Juni 1967, New York, US, SS. 390-397; R.M. HELLER: 'Forced-erasure decoding and the erasure reconstruction spectra of group codes'
- IEEE TRANSACTIONS ON INFORMATION THEORY, Bd. 18, Nr. 1, Januar 1972, New York, US, SS. 170-182; D. CHASE: 'A class of algorithms for decoding block codes with channel measurement information'

## Beschreibung

Die Erfindung geht aus von einem RDS-Empfänger nach der Gattung des Hauptanspruchs. Der Empfang von Daten, die mit Radiowellen übertragen werden, kann in vielfältiger Weise gestört sein. Es sind daher Verfahren zur Feststellung und/oder Korrektur von Übertragungsfehlern bekannt geworden. Bei dem sogenannten Radiodatensystem (RDS) wird ein Hilfsträger mit digital-codierten Signalen moduliert und zwar werden die Daten in Gruppen von jeweils 4 Datenworten übertragen, wobei jeweils ein Datenwort aus einem Informationswort von 16 Bits und einem Prüfwort von 10 Bits besteht. Das Prüfwort wird bei dem Radiodatensystem nach einem vorgegebenen Algorithmus aus dem Informationswort gebildet, wobei dem eigentlichen Prüfwort noch ein sogenanntes Offset-Wort überlagert wird, das zur Synchronisierung dient.

Beim Empfang wird nach der Demodulation mit Hilfe des Prüfwortes eine Fehlerprüfung sowie eine Fehlerkorrektur vorgenommen. Ein ausführliche Beschreibung des Radiodatensystems RDS liegt in der Druckschrift vor: "Specifications of the Radio Data System RDS for VHF/FM Sound Broadcasting", Techn. 3244 - E, März 1984, herausgegeben von der European Broadcasting Union (EBU).

Die bisher im Zusammenhang mit dem Radiodatensystem vorgeschlagenen Verfahren zum Empfang, einschließlich der Prüfung der empfangenen Daten, arbeiten jedoch nicht zufriedenstellend. Unter anderem wird die systembedingt beschränkte Fehlerkorrekturkapazität auch für Fehlermuster verwendet, die praktisch nicht vorkommen.

Aus der US 4 167 701 ist ein Decoder zur Fehlerkorrektur von codiert übertragenen Daten bekannt. In diesem Decoder werden in einem speziellen Schaltkreis Syndromwerte für die empfangenen Signale berechnet. Durch einen weiteren speziellen Schaltkreis wird sichergestellt, daß nur diejenigen als fehlerhaft erkannten Werte korrigiert werden, die während einer Phase empfangen wurden, während der die Feldstärke des empfangenen Signals unterhalb einer bestimmter Grenze vorliegt.

Aufgabe der Erfindung ist es ein Gerät zum Empfang von Daten, die mittels Radiowellen übertragen werden, anzugeben, bei welchem eine möglichst wirksame Fehlerkorrektur erfolgt. Ein erfindungsgemäßer RDS-Empfänger ist dadurch gekennzeichnet, daß zu den Korrekturversuchen, eine zweite Prüfmatrix K herangezogen wird, die aus der Paritätsprüfmatrix H dadurch herleitbar ist, daß die erste und die letzte Zeile der Paritätsprüfmatrix übernommen und die weiteren Zeilen der Paritätsprüfmatrix K durch eine Exclusiv-Oder-Verknüpfung benachbarter Zeilen der Paritätsprüfmatrix H gebildet werden, daß die Zeilen der Paritätsprüfmatrix K den Bits des Zuverlässigkeitswortes Q sowie dem letzten Bit des vorangegangen Zuverlässigkeitswortes zugeordnet sind, daß die den eine Unzuverlässigkeit anzeigenden F-Bits des Zuverlässigkeitswortes Q zugeordneten Zeilen S₁ bis S_{F} der Paritätsprüfmatrix K miteinander Exclusiv-Oder-verknüpft werden und daß dann, wenn eine der durch diese Verknüpfung gewonnenen Kombinationen den Wert "Null" aufweist, das Datenwort Y als ungültig behandelt wird. Mit Hilfe der erfindungsgemäßen Vorrichtung ist eine schnellere Datendecodierung möglich.

Die Zeilen S₁ bis S_{F} der Paritätsprüfmatrix K werden im Folgenden als Syndrome S₁ bis S_{F} bezeichnet.

Durch die in den abhängigen Ansprüchen angegebenen Maßnahmen werden vorteilhafte Weiterbildungen und Verbesserungen der erfindungsgemäßen Vorrichtung ermöglicht.

Für den erfindungsgemäßen RDS-Empfänger sind grundsätzlich auch festverdrahtete Schaltungen geeignet, obwohl die Durchführung der einzelnen Operationen mit Mikroprozessoren in vorteilhafter Weise ausgeführt werden kann. Dabei können die weiteren benötigten Komponenten, wie beispielsweise Speicher, an die Erfordernisse des erfindungsgemäßen Gerätes angepaßt sein. Je nach der jeweils gewählten Ausführung wirken sich weitere Weiterbildungen des erfindungsgemäßen Gerätes im Sinne einer Verringerung des Schaltungsaufwandes direkt oder im Sinne einer Verringerung der Rechenzeit aus, was letztlich auch zu einer Reduzierung des Aufwandes oder zu einer Erhöhung der Korrekturkapazität führt.

Ausführungsbeispiele der Erfindung sind in der Zeichnung anhand mehrerer Figuren dargestellt und in der nachfolgenden Beschreibung näher erläutert. Es zeigen:
- Fig. 1: ein Blockschaltbild eines erfindungsgemäßen Gerätes,
- Fig. 2: eine schematische Darstellung der Ableitung eines Syndroms,
- Fig. 3: eine tabellarische Darstellung zur Erläuterung der Ableitung der Kombinationen der weiteren Syndrome,
- Fig. 4: ein Flußdiagramm zur Ableitung der Kombinationen der weiteren Syndrome und zur Gewinnung einer Zahl, welche die zu korrigierenden Bits kennzeichnet,
- Fig. 5: eine Darstellung verschiedener digitaler Signale zur Ableitung eines Fehlerwortes,
- Fig. 6: ein Blockschaltbild einer Schaltungsanordnung zur Ableitung der weiteren Syndrome,
- Fig. 7: ein Blockschaltbild einer anderen Schaltungsanordnung zur Ableitung der weiteren Syndrome und
- Fig. 8: ein Blockschaltbild einer Anordnung zur Auswertung der Syndrome und zur Fehlerkorrektur.

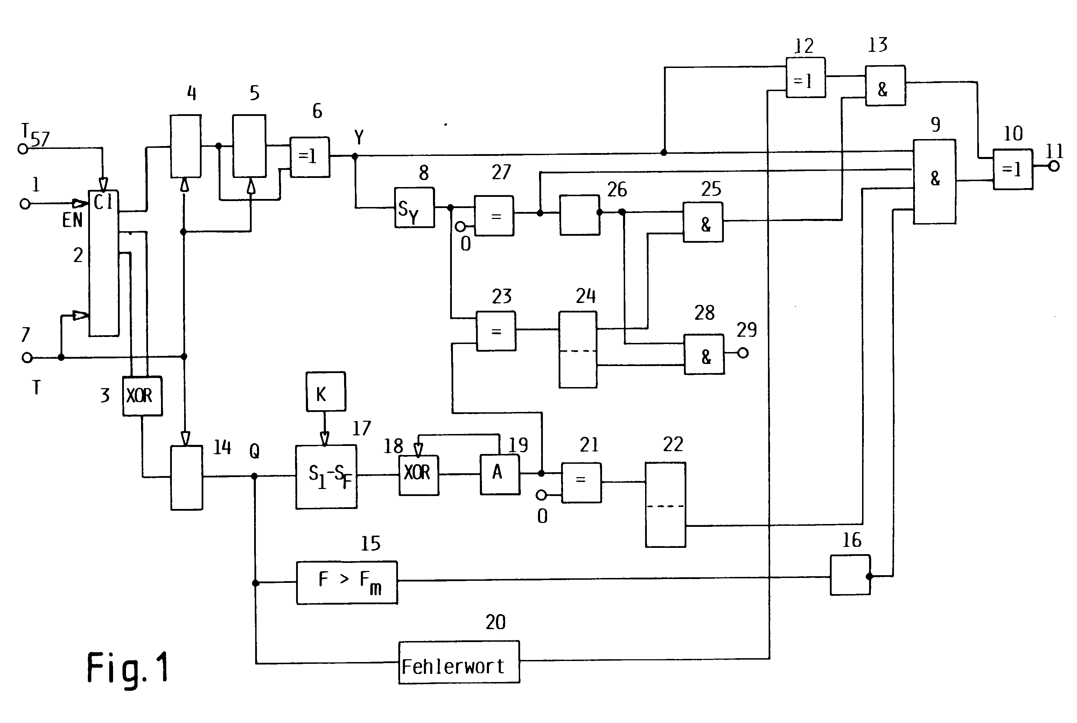

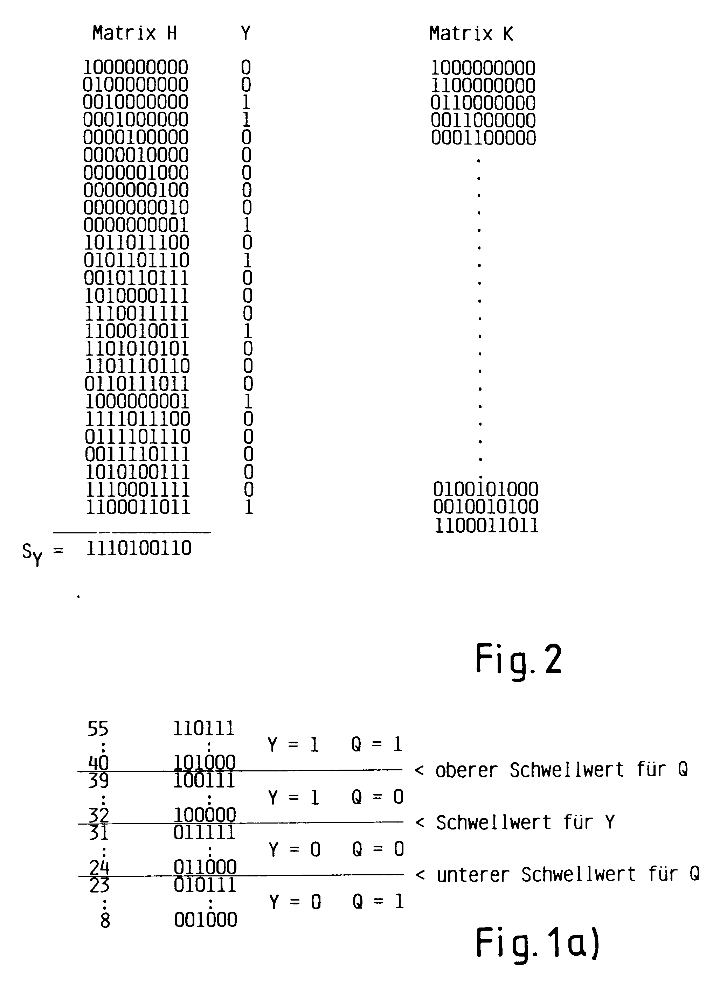

Das Blockschaltbild gemäß Fig. 1 zeigt stark vereinfacht ein erfindungsgemäßes Gerät, wobei lediglich die zum Verständnis erforderlichen Teile dargestellt sind. Weitere Einzelheiten, beispielsweise bei der Demodulation und der Wort- bzw. Bitsynchronisierung, sind in der Literatur, insbesondere in der eingangs genannten Veröffentlichung der EBU, ausreichend beschrieben. Ferner wurde der Übersichtlichkeit halber bei der Darstellung gemäß Fig. 1 auf den zeitlichen Ablauf bei der Signalverarbeitung im einzelnen nicht Rücksicht genommen. Dieser wird im Zusammenhang mit anderen Figuren genauer erläutert.

Das Ausgangssignal eines nicht dargestellten Demodulators wird über den Eingang 1 dem Freigabe (Enable)-Eingang eines 6-Bit-Zählers 2 zugeführt. Der 6-Bit-Zähler 2 wird mit einem Signal T₅₇ getaktet, dessen Frequenz bei dem Ausführungsbeispiel der Hilfträgerfrequenz von 57 kHz entspricht. Mit dem bei 7 zugeführten Bit-Takt T wird der 6-Bit-Zähler 2 auf einen Anfangswert gesetzt. Der jeweils vor dem Setzen erreichte Zählerstand ergibt nach der in Fig. 1a) dargestellten Tabelle ein Datensignal X und ein Zuverlässigkeitssignal Q. Dabei wird der Zähler auf den Anfangswert 8 gesetzt und zählt bis 55, also um 48 weiter, da beim RDS-System die Hilfsträgerfrequenz dem 48-fachen der Bitfrequenz entspricht.

Die Schwelle zur Bildung des Datensignals X liegt bei der Tabelle nach Fig. 1a) in der Mitte des Gesamtbereichs, so daß das höchstwertige Bit (MSB) des Zählerstandes direkt als Datensignal X verwendet werden kann. Die obere und die untere Schwelle für das Zuverlässigkeitssignal schließen die Schwelle für das Datensignal ein. Zwischen der oberen und der unteren Schwelle sind jeweils das zweite und das dritte Bit des Zählerstandes gleich, während unterhalb bzw. oberhalb dieser Schwellen das zweite und das dritte Bit verschieden sind. Es ist daher möglich, mit Hilfe einer Exklusiv-Oder-Schaltung 3 das Zuverlässigkeitssignal Q abzuleiten.

Die am Ende jeweils einer Bitperiode nur kurzzeitig anstehenden Bits des Datensignals X werden einem aus zwei Daten-Flip-Flops 4 und 5 sowie einer Exklusiv-Oder-Schaltung 6 bestehenden Differentialdecoder zugeführt. Die Flip-Flops werden mit dem bei 7 zugeführten Bit-Takt T getriggert, so daß mit Hilfe der Daten-Flip-Flops 4, 5 das binäre Signal jeweils um eine Taktperiode verzögert wird. Die Exklusiv-Oder-Schaltung 6 gibt eine 1 ab, wenn zwei aufeinanderfolgende Bits des empfangenen Signals verschiedene Werte aufweisen.

Bei dem Radiodatensystem werden die Informationen in Datenworten gesendet, von denen jeweils vier eine Gruppe bilden. Jedes der Datenworte besteht aus einem Informationswort mit 16 Bits und einem Prüfwort von 10 Bits, so daß die gesamte Länge des Datenwortes 26 Bits beträgt.

Aus dem am Ausgang des Differentialdecoders anstehenden Datenwort Y wird in an sich bekannter Weise bei 8 ein Syndrom S_{Y} gebildet. In Abhängigkeit vom Wert dieses Syndroms sowie der Werte weiterer Syndrome wird das Datenwort Y bzw. dessen Informationsteil entweder direkt über die UND-Schaltung 9 und die Oder-Schaltung 10 zum Ausgang 11 geleitet, von dem es zur weiteren Verarbeitung, beispielsweise für eine Anzeige, geleitet werden kann, oder zurückgehalten wird, wenn es unbrauchbar ist. Für den Fall von korrigierbaren Fehlern wird das Datenwort mit Hilfe der Exklusiv-OderSchaltung 12 korrigiert und über die UND-Schaltung 13 und die Oder-Schaltung 10 zum Ausgang 11 geleitet.

An den Ausgang der Exklusiv-Oder-Schaltung 3 ist ein Daten-Flip-Flop 14 angeschlossen, welches ebenfalls mit dem bei 7 zugeführten Takt T getaktet wird. Am Ausgang des Daten-Flip-Flops 14 steht dann ein digitales Signal Q an, bei welchem jeweils ein Bit einem Bit des Signals Y zugeordnet ist. Dieses Signal kennzeichnet die Zuverlässigkeit bzw. die Unzuverlässigkeit der einzelnen Bits des Signals Y vor der Differentialcodierung.

Da der Aufwand für die Auswertung des Zuverlässigkeitssignals stark mit der Anzahl der Unzuverlässigkeitsbits ansteigt und außerdem wegen der geringen Hamming-Distanz des für das Radiodatensystem gewählten Codes eine Korrektur vieler Fehler ohnehin nicht möglich ist, wird von vornherein die Auswertung eines Datenwortes, bei welchem das Zuverlässigkeitswort zuviele Unzuverlässigkeitsbits enthält, abgebrochen. Bei dem Ausführungsbeispiel gemäß Fig. 1 wird daher in einer Zähl- und Vergleichsschaltung 15 festgestellt, ob die Zahl F der Unzuverlässigkeitsbits größer als ein vorgegebener Wert Fₘ ist, wobei für Fₘ beispielsweise der Wert 6 in Frage kommt. Ist dieses der Fall, so wird von der Schaltung 15 eine 1 abgegeben, welche bei 16 invertiert wird, so daß die Weiterleitung des Datenwortes durch die UND-Schaltung 9 unterbunden wird - unabhängig davon, was die Auswertung im einzelnen ergibt.

Für jedes Unzuverlässigkeitsbit wird aus einer Matrix K ein Syndrom abgerufen, in einem Speicher 17 abgelegt und in einer Exklusiv-Oder-Schaltung 18 mit einem anderen Syndrom verknüpft, welches sich im Akkumulator 19 befindet. Sobald eine der Kombinationen den Wert 0 aufweist, was in einer Äquivalenzschaltung 21 festgestellt wird, wird ein Flip-Flop 22 gesetzt. Das Ausgangssignal des Flip-Flops verhindert über die UND-Schaltung 9 ebenfalls die Weiterleitung des Datenwortes zum Ausgang 11. Wenn irgendeine der Kombinationen der weiteren Syndrome also den Wert 0 aufweist, wird das Datenwort somit für ungültig erklärt.

In einer weiteren Äquivalenzschaltung 23 wird geprüft, ob eines der Syndrome dem Syndrom S_{Y} des Datenwortes entspricht. Ist dieses der Fall, so wird das Flip-Flop 24 gesetzt, dessen nichtinvertiertes Ausgangssignal mit Hilfe einer UND-Schaltung 25 mit dem bei 26 invertierten Ausgangssignal einer Äquivalenzschaltung 27 verknüpft wird. Am Ausgang der UND-Schaltung 25 steht dann eine 1 an, wenn eine der Kombinationen der weiteren Syndrome S₁ bis S_{F} dem Syndrom S_{Y} des Datenwortes Y entspricht und wenn diese Kombination bzw. das Syndrom S_{Y} nicht gleich 0 ist. In diesem Fall wird die UND-Schaltung 13 leitend und ein korrigiertes Datenwort wird zum Ausgang 11 geleitet. Zur Korrektur dient ein mit Hilfe der Schaltung 20 abgeleitetes Fehlerwort, das bei 12 mit dem Datenwort exklusiv-oder-verknüpft wird.

Ist keine der Kombinationen der weiteren Syndrome gleich dem Syndrom S_{Y} des Datenwortes, so bleibt das Flip-Flop 24 ungesetzt und gibt an seinem invertierenden Ausgang eine 1 an die UND-Schaltung 28 ab, an deren Ausgang ein Signal ansteht, wenn außerdem das Syndrom S_{Y} ungleich 0 ist. Dieses bedeutet, daß das Datenwort Y nicht korrigierbar ist.

In der folgenden Tabelle sind die im Zusammenhang mit Fig. 1 beschriebenen verschiedenen Möglichkeiten zusammengestellt:

| | | |
|---|---|---|
| F > Fₘ | Wort ungültig - keine Bearbeitung | |
| F ≤ Fₘ | irgendeine XOR-Kombination | |
| | der Syndrome S₁ bis S_{F} = 0 - Wort ungültig | |
| | keine Kombination | |
| | der Syndrome S₁ bis S_{F} = 0 | |
| | keine Kombination = S_{Y} | |
| | S_{Y} = 0 | Y in Ordnung |
| | S_{Y} ungleich 0 | Y nicht korrigierbar |
| | eine Kombination = S_{Y} | |
| | S_{Y} ungleich 0 | Y korrigiert |

Zur Erläuterung der Syndrombildung ist in Fig. 2 die in der obengenannten EBU-Veröffentlichung vorgeschlagene Paritätsprüfmatrix H sowie ein Beispiel eines Datenwortes Y und des aus diesem Datenwort und der Matrix H gebildeten Syndroms S_{Y} dargestellt. Die Matrix H besteht aus 26 Zeilen mit jeweils 10 Spalten. Die Berechnung des Syndroms S_{Y} für das Datenwort Y erfolgt nun derart, daß alle Zeilen der Matrix H miteinander exklusiv-oder-verknüpft werden, bei welchen das Datenwort den Wert 1 aufweist. Durch die mehrfache Exklusiv-Oder-Verknüpfung gibt sich bekanntlich bei Vorliegen einer ungeraden Anzahl von Einsen eine 1 und bei einer geraden Anzahl von Einsen eine 0.

Durch die Differential-Codierung entstehen aus einem 1-Bit-Fehler des Signals auf der Übertragungsstrecke 2-Bit-Fehler bei dem Datenwort Y. Bei der Erzeugung des Zuverlässigkeitswortes Q wird die Dauer der Fehler auf der Übertragungsstrecke nicht vergrößert, so daß jeweils ein einzelnes Unzuverlässigkeitsbit auf einen 1-Bit-Fehler auf der Übertragungsstrecke, also auf einen 2-Bit-Fehler im Datenwort Y hinweist. Aus diesem Grunde erfolgt die Syndrombildung aus den Unzuverlässigkeitsbits mit Hilfe einer Matrix K, welche in Fig. 2 teilweise dargestellt und aus der Matrix H wie folgt abgeleitet ist:
Die erste und die letzte Zeile entsprechen der Matrix H, während die dazwischenliegenden Zeilen jeweils durch eine Exklusiv-Oder-Verknüpfung der benachbarten Zeilen der H-Matrix gebildet sind. Die Matrix K weist somit 27 Zeilen auf. Dieses ermöglicht die Berücksichtigung des letzten Bits des vorangegangenen Zuverlässigkeitswortes.

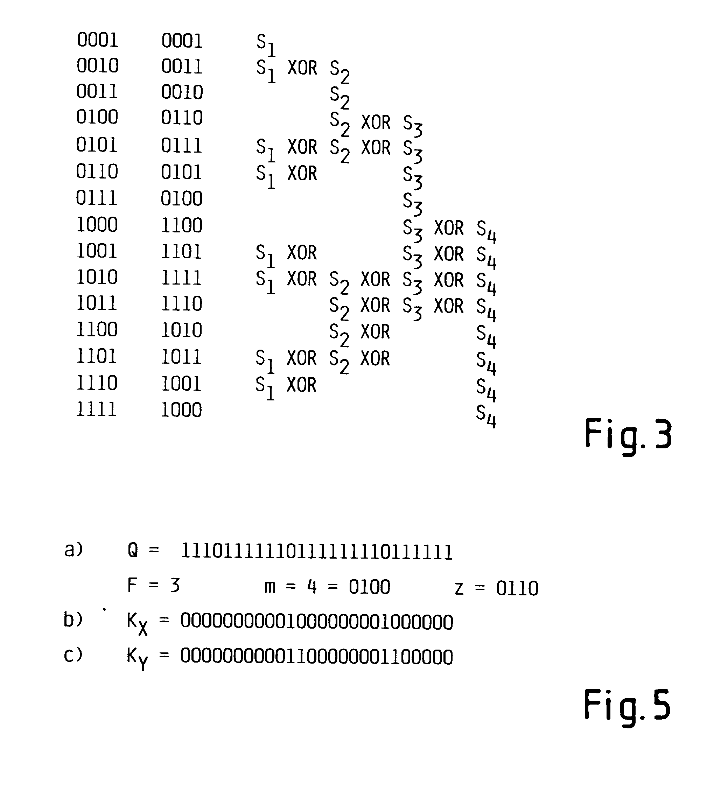

Mit Hilfe der Matrix K werden die Syndrome aller einzelnen Unzuverlässigkeitsbits gebildet und bei 17 (Fig. 1) abgespeichert. Der Rechenaufwand zur Exklusiv-Oder-Verknüpfung der Syndrome S₁ bis S_{F} kann erheblich reduziert werden, wenn nach einer Weiterbildung der Erfindung vorgegangen wird, welche im Zusammenhang mit Fig. 3 im folgenden erläutert wird.

Es wird dabei von maximal vier auszuwertenden Unzuverlässigkeitsbits ausgegangen. Die Zahl n stellt eine Zählvariable dar, aus welcher nach einem Gray-Code die Zahl z errechnet wird, die jeweils angibt, welche der weiteren Syndrome S₁ bis S₄ exlusiv-oder zu verknüpfen sind. Der Einfachheit halber wurde eine Exklusiv-Oder-Verknüpfung in der Zeichnung durch die Abkürzung XOR dargestellt. Dabei bewirkt die Anwendung des Gray-Codes, bei dem sich von Zeile zu Zeile immer nur ein Bit ändert, daß vom Speicher 17 in die Exklusiv-Oder-Verknüpfung 18 für jeden neuen Rechenschritt nur ein neues Syndrom übernommen wird. Dabei wird bei n = 15 das Syndrom S₄ ohne Verknüpfung an den Ausgang der Schaltung 19 (Fig. 1) weitergeleitet; bei n = 14 (= 1110) werden die Syndrome bis S₁ und S₄ miteinander verknüpft, danach wird zusätzlich das Syndrom S₂ aus dem Speicher gelesen und mit den Syndromen S₁ und S₄ verknüpft usw.. Aus jeder Kombination entsteht durch eine einzige Exklusiv-Oder-Verknüpfung eine neue Kombination.

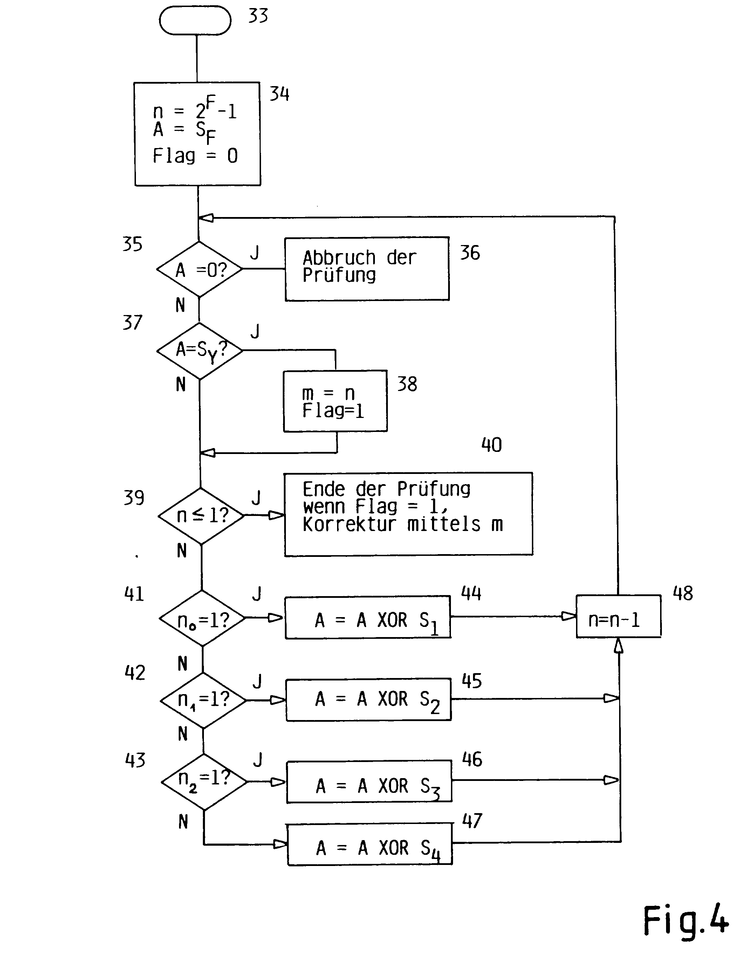

Fig. 4 zeigt ein Flußdiagramm für die im Zusammenhang mit Fig. 3 erläuterte Kombination der weiteren Syndrome. Nach dem Start des Programms bei 33 wird bei 34 die Zählvariable n auf die Zahl der möglichen Kombinationen bei F Unzuverlässigkeitsbits gesetzt. Außerdem wird in einem Akkumulator A das Syndrom S_{F} eingelesen und ein Merker (Flag) = 0 gesetzt. Danach wird bei 35 geprüft, ob der Inhalt des Akkumulators, also beim ersten Programmdurchlauf das Syndrom S_{F} gleich 0 ist. Ist dieses der Fall, wird die Prüfung bei 36 abgebrochen. Ist der Inhalt des Akkumulators A ungleich 0, wird geprüft, ob der Inhalt des Akkumulators mit dem Syndrom S_{Y} übereinstimmt. Zutreffendenfalls wird der Merker auf 1 und eine Zahl m gleich der Zahl n gesetzt. Letzteres dient dazu, beim späteren Ende der Prüfung diejenige Kombination festgehalten zu haben, bei welcher A = S_{Y} ist.

Bei 39 wird geprüft, ob die Zählvariable n den Wert 1 erreicht hat, wenn dieses der Fall ist und der Merker auf 1 gesetzt ist, wird bei 40 die Zahl m zur Korrektur des Datenwortes ausgegeben.

Solange n noch nicht den Wert 1 erreicht hat, wird mit Hilfe der Programmschritte 41 bis 43 jeweils geprüft, ob jeweils eines der Bits n₀ bis n₂ (n₀ = LSB) der Dualzahl n den Wert 1 hat. Damit erfolgt eine Aufteilung des weiteren Programmablaufs nach einm Gray-Code zu den Exklusiv-Oder-Verknüpfungen 44 bis 47. In diesen Programmteilen wird jeweils der Inhalt A des Akkumulators durch Exklusiv-Oder-Verknüpfung des vorangegangenen Akkumulatorinhalts mit einem der Syndrome S₁ bis S₄ ermittelt. Danach wird die Zählvariable n bei 48 dekrementiert und das Programm bei 35 fortgesetzt.

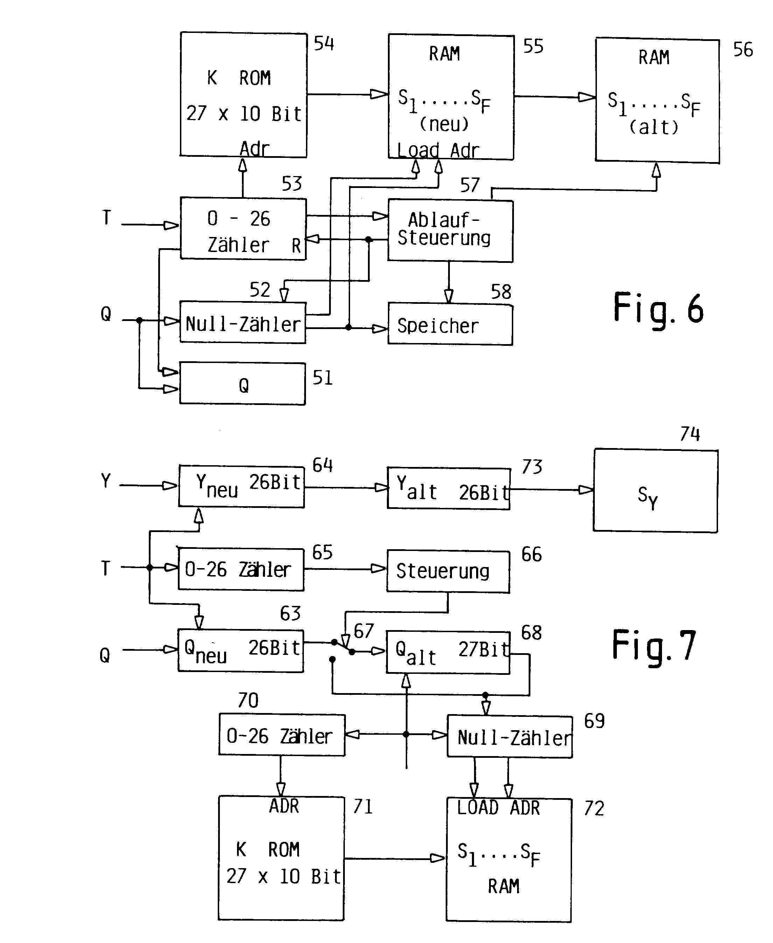

Die Erzeugung des Fehlerwortes, das zur Korrektur des Datenwortes Y herangezogen wird, wird im folgenden an Hand von Fig. 5 erläutert. Bei dem in Zeile a) dargestellten Zuverlässigkeitswort bedeutet eine 0 ein Unzuverlässigkeitsbit, während ein Bit mit dem Wert 1 bedeutet, daß ein Fehler durch die Übertragung unwahrscheinlich ist. Da drei Unzuverlässigkeitsbits vorliegen, ist F = 3, so daß das in Fig. 4 dargestellte Programm bei n = 7 beginnt.

Wird bei n = 4 festgestellt, daß der Inhalt A des Akkumulators gleich dem Syndrom S_{Y} des Datenwortes ist, so wird auch m = 4 gesetzt. Dieses entspricht der Dualzahl 0100. Aus einer Tabelle gemäß Fig. 3 kann der zugehörige Wert von z = 0110 entnommen werden, was wiederum einer Exklusiv-Oder-Verknüpfung der Syndrome S₂ und S₃ entspricht. Die erste Null des Zuverlässigkeitswortes Q bedeutet also keinen Fehler, während die zweite und die dritte Null auf einen Fehler schließen lassen. Es wird daher ein Korrekturwort erzeugt, bei dem diejenigen Bits den Wert 1 aufweisen, welche dem zweiten und dritten Unzuverlässigkeitsbits des Zuverlässigkeitswortes Q entsprechen.

Dieses in Zeile b) der Fig. 5 dargestellte Fehlerwort K_{X} bezieht sich jedoch auf Fehler auf der Übertragungsstrecke. Da durch die Differentialcodierung jedoch eine Fehlerverdoppelung stattfindet, wird aus diesem Fehlerwort das in Zeile c) dargestellte Fehlerwort K_{Y} erzeugt. Dieses kann in einfacher Weise dadurch geschehen, daß das in Zeile b) dargestellte Fehlerwort K_{X} um eine Stelle nach rechts verschoben und mit dem nach rechts verschobenen Fehlerwort exklusiv-oder-verknüpft wird. Das in Fig. 5c) dargestellte Fehlerwort wird zur Fehlerkorrektur mit dem Datenwort Y exklusiv-oder-verknüpft (Schaltung 12 in Fig. 1).

Wie bereits angedeutet, wurde übersichtlichkeitshalber bei dem Blockschaltbild gemäß Fig. 1 auf die zeitliche Abfolge der einzelnen Verfahrensschritte zunächst nicht eingegangen. Die Bereitstellung der weiteren Syndrome S₁ bis S_{F} sowie die Ermittlung der Anzahl F der Unzuverlässigkeitsbits kann zwar während des Einlesens des Zuverlässigkeitswortes und des Datenwortes erfolgen, die weitere Auswertung kann jedoch erst am Ende des 26-Bit-Wortes beginnen. Dann fängt jedoch bereits das folgende 26-Bit-Wort an. Es ist daher eine Zwischenspeicherung erforderlich. Diese Zwischenspeicherung wird im Zusammenhang mit den Figuren 6 und 7 näher erläutert. Dabei werden die bei dem Ausführungsbeispiel nach Fig. 6 zur Auswertung erforderlichen Daten, also die weiteren Syndrome und die Anzahl der Unzuverlässigkeitsbits gespeichert, während bei dem Ausführungsbeispiel nach Fig. 7 das Datenwort und das Zuverlässigkeitswort zwischengespeichert werden.

Bei der Anordnung nach Fig. 6 wird das Zuverlässigkeitswort Q in ein Register 51 eingeschrieben und dem Eingang eines Zählers 52 zugeführt, welcher jeweils bei einer Null (= Unzuverlässigkeit) inkrementiert wird. Das Taktsignal T wird einem Zähler 53 zugeführt, der entsprechend der Wortlänge von 0 bis 26 zählt. In einem Nur-Lese-Speicher 54 sind die Syndrome für jedes einzelne Bit des Zuverlässigkeitswortes Q abgelegt. Bei dem ersten Taktimpuls wird aus dem Nur-Lese-Speicher 54 dasjenige Syndrom ausgelesen, welches einem Zuverlässigkeitswort Q entspricht, das aus einer 0 und 26 Einsen besteht, beim zweiten Taktimpuls dasjenige Syndrom, was einem Zuverlässigkeitswort 10 und 25 Einsen entspricht usw.. Ein mit dem Nur-Lese-Speicher 54 verbundener Schreib-Lese-Speicher 55 ist mit seinem Load-Eingang und seinem Adresseneingang an den Zähler 52 angeschlossen. Dabei entspricht die Adresse, unter der ein Syndrom im Schreib-Lese-Speicher 55 geladen wird, demjeweiligen Zählerstand, während ein Syndrom nur dann eingeschrieben wird, wenn das Zuverlässigkeitswort eine Null aufweist.

Am Ende des Zuverlässigkeitswortes Q befinden sich im Schreib-Lese-Speicher 55 diejenigen Syndrome, welche den Unzuverlässigkeitsbits entsprechen. Da die bisher beschriebenen Vorgänge mit Beginn des darauffolgenden Zuverlässigkeitswortes Q erneut ablaufen, werden die im Schreib-Lese-Speicher 55 gespeicherten Syndrome S₁ bis S_{F} in einen weiteren Schreib-Lese-Speicher 56 übertragen. Eine Ablaufsteuerschaltung 57 sorgt dafür, daß die Zähler 52, 53 zurückgesetzt werden und daß vorher der Zählerstand des Zählers 52 in einen Speicher 58 für die Anzahl der Unzuverlässigkeitsbits übertragen werden.

Die Auswertung der weiteren Syndrome, die im Schreib-Lese-Speicher 56 abgelegt sind, sowie des im Register 51 zwischengespeicherten Zuverlässigkeitswortes Q erfolgt dann in der im Zusammenhang mit den Figuren 4 und 5 beschriebenen Weise, während in den Schreib-Lese-Speicher 55 die Syndrome des folgenden Zuverlässigkeitswortes Q eingeschrieben werden.

Bei der Anordnung nach Fig. 7 werden das Datenwort Y und das Zuverlässigkeitswort Q in jeweils ein Register 63, 64 im Takt T eingeschrieben. Ferner wird durch das Taktsignal T ein Zähler 65 angesteuert, welcher von 0 bis 26 zählt. Eine an den Ausgang des Zählers 65 angeschlossene Steuerschaltung 66 steuert unter anderem einen Umschalter 67 am Eingang des weiteren Registers 68, in welches das Zuverlässigkeitswort nach dem Durchlaufen des Registers 63 eingeschrieben wird. Während das neue Zuverlässigkeitswort in das Register 63 eingeschrieben wird, wird das vorangegangene aus dem Ausgang des Registers 68 ausgelesen und zum Eingang des gleichen Registers über den Umschaltetr 67 zurückgeführt. Während dieser Zeit zählt ein Zähler 69 die Unzuverlässigkeitsbits und ein weiterer Zähler 70 die Taktimpulse, die während dieser Zeit auftreten.

Aus dem Zählerstand des Zählers 70 werden - wie bereits im Zusammenhang mit der Anordnung nach Fig. 6 erläutert - Adressen zum Auslesen der weiteren Syndrome aus einem Nur-Lese-Speicher 71 gewonnen, während der Zählerstand des Zählers 69 als Adresse zum Einlesen der Syndrome, welche den Unzuverlässigkeitsbits entsprechen, dient. Der Inhalt des Zählers 69 sowie des Schreib-Lese-Speichers 72 kann wie im Zusammenhang mit den Figuren 4 und 5 beschrieben, zur Auswertung und Fehlerkorrektur benutzt werden.

Bei der Anordnung nach Fig. 7 wird das Datenwort Y ebenfalls in einem weiteren Register 73 zwischengespeichert und dann in der Schaltung 74 zur Bildung des Syndroms S_{Y} verwendet.

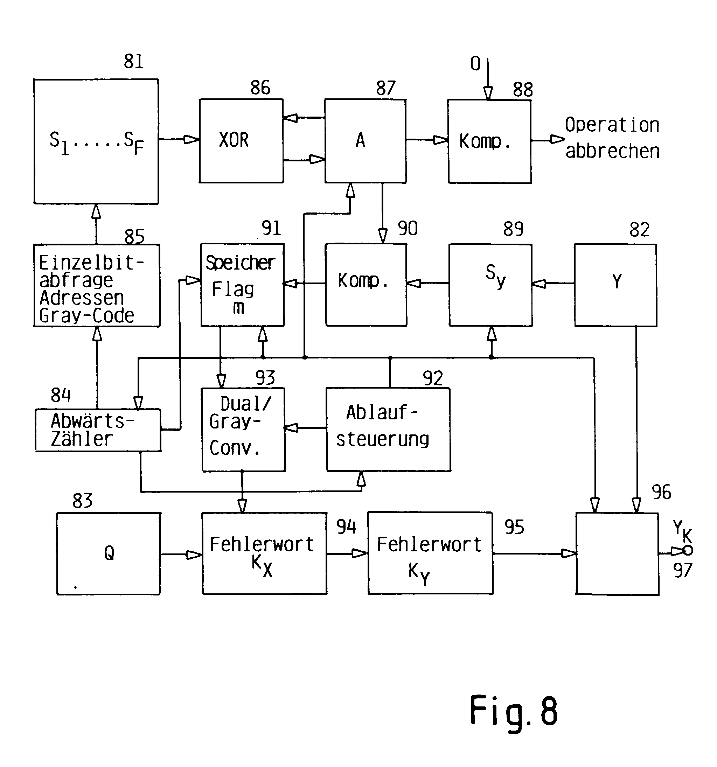

Fig. 8 zeigt ein Blockschaltbild einer Anordnung zur Auswertung der Syndrome S_{Y} und S₁ bis S_{F}. Dabei sind die Syndrome S₁ bis S_{F} in einem Speicher 81 abgelegt, der beispielsweise einer der Schreib-Lese-Speicher 56 (Fig. 6) oder 72 (Fig. 7) sein kann. Das zu prüfende bzw. zu korrigierende Datenwort Y befindet sich in einem Speicher 82, während das zugehörige Zuverlässigkeitswort Q bei 83 abgelegt ist.

Ein Abwärtszähler 84 wird auf einen Anfangswert n₀ gesetzt, wozu die Zahl F der Unzuverlässigkeitsbits vom Speicher 58 (Fig. 6) oder vom Zähler 59 (Fig. 7) übernommen wird und n₀ nach der Gleichung 2^{F}-1 berechnet wird. In einem Adressengenerator 85 werden gemäß der Tabelle in Fig. 3 durch Anwendung des Gray-Codes Adressen zum Auslesen der Syndrome S₁ bis S_{F} aus dem Speicher 81 gewonnen.

Eine Exklusiv-Oder-Schaltung 86 verknüpft das jeweils ihr zugeführte Syndrom mit dem im Akkumulator 87 gespeicherten Syndrom und schreibt das erhaltene Syndrom in den Akkumulator 87 ein. Der Inhalt des Akkumulators 87 wird mit Hilfe eines Komparators 88 mit dem Wert 0 verglichen. Sobald ein Syndrom oder eine Kombination von Syndromen im Akkumulator 87 den Wert 0 aufweist, wird vom Komparator ein Signal abgegeben, welches den Abbruch der Operation bedeutet.

Der Inhalt des Komparators 87 wird ferner mit dem Syndrom S_{Y} verglichen, welches in einer Schaltung 89 aus dem Datenwort Y nach dem in Fig. 2 dargestellten Rechenverfahren gewonnen wird. Zum Vergleich des Akkumulatorinhalts und des Syndroms S_{Y} ist ein 10-Bit-Komparator 90 vorgesehen, dessen Ausgang mit einem Speicher 91 verbunden ist, in welchem ein Merker (Flag) sowie eine Zahl m gespeichert werden können. Die Zahl m stellt denjenigen Stand des Zählers 84 dar, bei welchem der Inhalt des Akkumulators 87 gleich dem Syndrom S_{Y} ist, und markiert somit diejenige Kombination von Unzuverlässigkeitsbits, welche zur Gleichheit zwischen A und S_{Y} geführt haben.

Die zeitlichen Vorgänge beim Betrieb der Anordnung nach Fig. 8 werden von einer Ablaufsteuerung 92 gesteuert. Dieser wird unter anderem vom Zähler 84 ein Signal zugeführt, wenn der Zählerstand n gleich 1 ist. Wird dieses erreicht, ohne daß der Inhalt A des Akkumulators 87 den Wert 0 erreicht hat und das Flag gleich 0 ist, so wird von der Ablaufsteuerung 92 der Dual/Gray-Converter 93 aktiviert, welcher die Zahl m nach dem Gray-Code umwandelt, wodurch - wie im Zusammenhang mit Fig. 5 beschrieben - diejenigen Bits des Zuverlässigkeitswortes Q, welche auf korrekturfähige Bits des Wortes Y hinweisen, festgelegt werden. Ein diese Bits umfassender Korrekturwert K_{X} wird in der Schaltung 94 erzeugt. In der Schaltung 95 wird K_{X} in K_{Y} umgewandelt und in der Korrekturschaltung 96 mit dem Datenwort Y exklusiv-oder-verknüpft, welche an ihrem Ausgang 97 ein korrigiertes Datenwort Y_{K} abgibt.

## Patentansprüche

1. RDS-Empfänger, in welchem aus einem empfangenen Datenwort X durch Differentialdecodierung ein Datenwort Y gewonnen wird und aus diesem Datenwort Y und einer ihm zugeordneten Paritätsprüfmatrix H ein Syndrom S_{Y} gebildet wird und in dem ein binäres Zuverlässigkeitswort Q beim Empfang des Datenwortes X erzeugt wird, dessen Bits den Bits des Datenwortes Y zugeordnet sind und mit denen Korrekurversuche veranlaßt werden, sofern die Zahl der eine Unzuverlässigkeit anzeigenden Bits in dem Zuverlässigkeitswort Q eine vorgegebene Höchstzahl F nicht überschreitet, dadurch gekennzeichnet, daß zu den Korrekturversuchen eine zweite Paritätsprüfmatrix K herangezogen wird, die aus der Paritätsprüfmatrix H dadurch herleitbar ist, daß die erste und die letzte Zeile der Paritätsprüfmatrix H übernommen und die weiteren Zeilen der Paritätsprüfmatrix K durch eine Exclusiv-Oder-Verknüpfung benachbarter Zeilen der Paritätsprüfmatrix H gebildet werden, daß die Zeilen der Paritätsprüfmatrix K den Bits des Zuverlässigkeitswortes Q sowie dem letzten Bit des vorangegangenen Zuverlässigkeitswortes zugeordnet sind, daß die den eine Unzuverlässigkeit anzeigenden F Bits des Zuverlässigkeitswortes Q zugeordneten Zeilen S₁ bis S_{F} der Paritätsprüfmatrix K miteinander Exclusiv-Oder-verknüpft werden und daß dann, wenn eine der durch diese Verknüpfung gewonnenen Kombinationen den Wert Null aufweist, das Datenwort Y als ungültig behandelt wird.

2. RDS-Empfänger nach Anspruch 1, dadurch gekennzeichnet, daß dann, wenn keine der Kombinationen den Wert Null aufweist und gleichzeitig jede ungleich S_{Y} ist und S_{Y} ungleich Null ist, das Datenwort Y als nichtkorrigierbar behandelt wird.

3. RDS-Empfänger nach Anspruch 1 und 2, dadurch gekennzeichnet, daß dann, wenn sowohl alle Kombinationen als auch S_{Y} ungleich Null sind und eine der Kombinationen gleich S_{Y} ist, das Datenwort Y korrigiert wird.

4. RDS-Empfänger nach Anspruch 1, dadurch gekennzeichnet, daß die Exclusiv-Oder-Verknüpfung der Zeilen S₁ bis S_{F} der Paritätsprüfmatrix K nach einer derartigen Reihenfolge durchgeführt wird, daß eine die Auswahl der jeweils zu verknüpfenden Zeilen S₁ bis S_{F} darstellende Binärzahl sich jeweils nur in einer Binärstelle ändert (Gray-Code).

5. RDS-Empfänger nach Anspruch 4, dadurch gekennzeichnet, daß bei der Prüfung der Kombinationen der Zeilen S₁ bis S_{F} eine Zählvariable verwendet wird, aus welcher nach einem Gray-Code die zu kombinierenden Syndrome ausgewählt werden, und daß bei dem höchsten, sich aus der Anzahl der Unzuverlässigkeitsbits ergebenden Zählwert begonnen und abwärts gezählt wird.

6. RDS-Empfänger nach einem der Ansprüche 1 bis 5, dadurch gekennzeichnet, daß die Zeilen S₁ bis S_{F} der Paritätsprüfmatrix K jeweils bis zum Ablauf des Datenwortes gespeichert werden, welches auf das den Zeilen S₁ bis S_{F} zugeordnete Datenwort folgt.

7. RDS-Empfänger nach Anspruch 6, dadurch gekennzeichnet, daß jeweils während eines Datenwortes die zugeordneten Zeilen S1 bis SF in einen ersten Speeicher eingeschrieben und am Ende des jeweiligen Datenwortes in einen zweiten Speicher übertragen werden.

8. RDS-Empfänger nach einem der Ansprüche 1 bis 5, dadurch gekennzeichnet, daß das jeweilige Datenwort und das jeweilige Zuverlässigkeitswort während des Empfangs des darauffolgenden Datenwortes zwischengespeichert werden.

9. RDS-Empfänger nach einem der Ansprüche 1 bis 5, dadurch gekennzeichnet, daß das jeweilige Datenwort und die Positionen der Unzuverlässigkeitsbits während des Empfangs des darauffolgenden Datenwortes gespeichert werden.

## Claims

1. RDS receiver, in which a data word Y is obtained from a received data word X by differential decoding and a syndrome S_{Y} is formed from this data word Y and a parity checking matrix H assigned to it, and in which a binary reliability word Q is generated upon receiving the data word X, the bits of which are assigned to the bits of the data word Y and with which correction attempts are initiated provided that the number of bits indicating an unreliability in the reliability word Q does not exceed a predetermined maximum number F, characterized in that for the correction attempts a second parity checking matrix K is used, which can be derived from the parity checking matrix H by the first and the last row of the parity checking matrix H being taken over and the other rows of the parity checking matrix K being formed by an exclusive-OR operation on neighbouring rows of the parity checking matrix H, in that the rows of the parity checking matrix K are assigned to the bits of the reliability word Q and to the last bit of the preceding reliability word, in that the rows S₁ to S_{F} of the parity checking matrix K assigned to the F bits of the reliability word Q indicating an unreliability are combined with one another by an exclusive-OR operation and in that whenever one of the combinations obtained by this operation has the value zero the data word Y is treated as invalid.

2. RDS receiver according to Claim 1, characterized in that whenever none of the combinations has the value zero and at the same time each is unequal to S_{Y} and S_{Y} is unequal to zero, the data word Y is treated as uncorrectable.

3. RDS receiver according to Claims 1 and 2, characterized in that whenever both all combinations and S_{Y} are unequal to zero and one of the combinations is equal to S_{Y} the data word Y is corrected.

4. RDS receiver according to Claim 1, characterized in that the exclusive-OR operation on the rows S₁ to S_{F} of the parity checking matrix K is carried out according to such a sequence that a binary number representing the selection of the rows S₁ to S_{F} respectively to be combined changes in each case only in one binary position (Gray code).

5. RDS receiver according to Claim 4, characterized in that in the checking of the combinations of the rows S₁ to S_{F} a counting variable is used, from which the syndromes to be combined are selected on the basis of a Gray code, and in that counting begins with the highest count value resulting from the number of unreliability bits and proceeds downwards.

6. RDS receiver according to one of Claims 1 to 5, characterized in that the rows S₁ to S_{F} of the parity checking matrix K are respectively stored up to the end of the data word which follows the data word assigned to the rows S₁ to S_{F}.

7. RDS receiver according to Claim 6, characterized in that in each case during a data word the assigned rows S₁ to S_{F} are written to a first memory and, at the end of the respective data word, are transferred into a second memory.

8. RDS receiver according to one of Claims 1 to 5, characterized in that the respective data word and the respective reliability word are buffer-stored during the reception of the following data word.

9. RDS receiver according to one of Claims 1 to 5, characterized in that the respective data word and the positions of the unreliability bits are stored during the reception of the following data word.

## Revendications

1. Récepteur RDS qui, à partir d'un mot de donnée X reçu, forme un mot de donnée Y par codage différentiel et, à partir de ce mot de donnée Y et de la matrice de contrôle de parité X associée, forme un syndrome S_{Y}, et génère un mot de confiance Q, binaire, à la réception du mot de donnée X dont les bits sont associés aux bits du mot de donnée Y et servent à des essais de corrections dans la mesure où des bits indiquant une non-confiance dans le mot de confiance Q ne dépassent pas un nombre maximum F prédéterminé, récepteur caractérisé en ce que, pour les essais de corrections, il utilise une seconde matrice de contrôle de parité K déduite de la matrice de contrôle de parité H, en reprenant la première et la dernière ligne de la matrice de contrôle de parité H et en formant les autres lignes de la matrice de contrôle de parité K par une combinaison logique OU-Exclusif de lignes voisines de la matrice de contrôle de parité H, en associant les lignes de la matrice de contrôle de parité K aux bits du mot de confiance Q ainsi qu'au dernier bit du mot de confiance précédent, et les lignes S₁ jusqu'à S_{F} de la matrice de contrôle de parité K qui sont associées aux F bits du mot de confiance Q indiquant une non-confiance, sont combinés entre eux par une combinaison logique OU-Exclusif et, si l'une des combinaisons ainsi obtenues par combinaison logique présente la valeur zéro, le mot de donnée Y est traité comme non valable.

2. Récepteur RDS selon la revendication 1, caractérisé en ce que le mot de donnée Y est traité comme ne pouvant être corrigé si aucune des combinaisons ne présente la valeur zéro et qu'en même temps chacune est différente de S_{Y,} et si S_{Y} est différent de zéro.

3. Récepteur RDS selon les revendications 1 et 2, caractérisé en ce que, si toutes les combinaisons de même que S_{Y} sont différents de zéro et qu'une des combinaisons est égale à S_{Y}, on corrige le mot de donnée Y.

4. Récepteur RDS selon la revendication 1, caractérisé en ce que la combinaison OU-Exclusif de toutes les lignes S₁...S_{F} de la matrice de contrôle de parité K se fait dans un ordre tel qu'un nombre binaire qui représente la sélection des lignes S₁...S_{F} à combiner respectivement, ne change chaque fois que d'une position binaire (code de Gray).

5. Récepteur RDS selon la revendication 4, caractérisé en ce que, pour le contrôle des combinaisons des lignes S₁ jusqu'à S_{F}, on utilise une variable de comptage à l'aide de laquelle on sélectionne les syndromes à combiner selon un code de Gray et en ce que l'on commence pour l'état de comptage le plus élevé résultant du nombre des bits de non-confiance et on procède par décomptage.

6. Récepteur RDS selon l'une des revendications 1 à 5, caractérisé en ce qu'on enregistre les lignes S₁ jusqu'à S_{F} de la matrice de contrôle de parité K chaque fois jusqu'à la fin du mot de donnée suivant le mot de donnée associé aux lignes S₁ jusqu'à S_{F}.

7. Récepteur RDS selon la revendication 6, caractérisé en ce que chaque fois pendant un mot de donnée, on enregistre les lignes associées S₁...S_{F} dans une première mémoire et, à la fin du mot de donnée respectif, on transfère dans une seconde mémoire.

8. Récepteur RDS selon l'une des revendications 1 à 5, caractérisé en ce que le mot de donnée respectif et le mot de confiance correspondant sont enregistrés de façon intermédiaire pendant la réception du mot de donnée suivant.

9. Récepteur RDS selon l'une des revendications 1 à 5, caractérisé en ce que le mot de donnée respectif et les positions du bit de non-confiance sont enregistrés pendant la réception du mot de donnée suivant.
